# EUROPEAN PATENT SPECIFICATION

(11) **EP 3 109 647 B1**
(45) Date of publication and mention of the grant of the patent: **18.11.2020**
(21) Application number: 15174063.6
(22) Date of filing: 26.06.2015
(51) Int. Cl.: G01R 27/18, G01R 27/02, G01R 31/52

(54) **METHOD AND ARRANGEMENT FOR MEASURING INSULATION RESISTANCE OF PHOTOVOLTAIC SYSTEM**
VERFAHREN UND ANORDNUNG ZUR MESSUNG DES ISOLATIONSWIDERSTANDS EINES PHOTOVOLTAIKSYSTEMS
PROCÉDÉ ET DISPOSITIF DE MESURE PERMETTANT DE MESURER LA RÉSISTANCE D'ISOLATION D'UN SYSTÈME PHOTOVOLTAÏQUE

(43) Date of publication of application: 28.12.2016
(73) Proprietor: MARICI Holdings The Netherlands B.V., 3068AX Rotterdam (NL)
(72) Inventor: Kohvakka, Kimmo, 00380 Helsinki (FI); Sjögren, Janne, 00380 Helsinki (FI); Riipinen, Tomi, 00380 Helsinki (FI)
(74) Representative: Kolster Oy Ab

(56) References cited:
- EP-A1- 0 654 673
- EP-A2- 2 466 320
- WO-A1-2012/098677
- DE-C1- 10 106 200

## Description

### FIELD OF THE INVENTION

The invention relates to a method and an arrangement for measuring an insulation resistance of a photovoltaic system, and to a photovoltaic system.

### BACKGROUND OF THE INVENTION

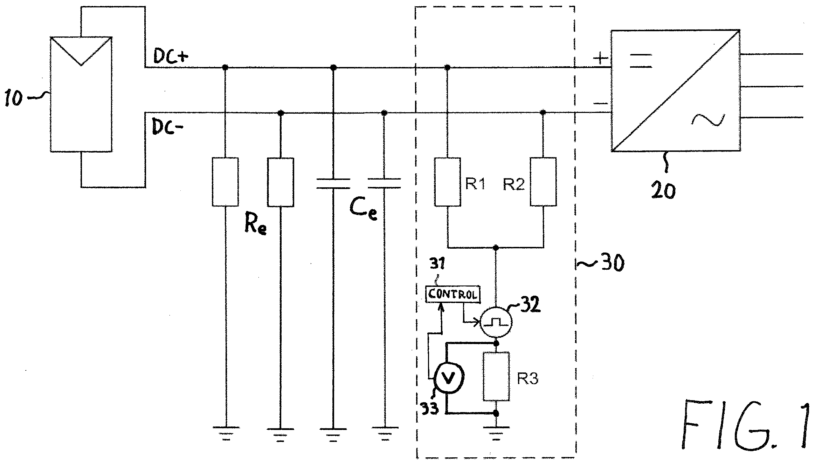

Photovoltaic systems may comprise one or more photovoltaic (PV) panels configured to provide a DC output. An example of a photovoltaic system is a photovoltaic generator, in which, as illustrated in Figure 1, one or more photovoltaic panels 10 supply DC power via a DC link DC+, DC- to one or more inverters 20 which convert the DC power to AC power, which may further be supplied to various AC loads via an AC network (grid), for example. Large photovoltaic power plants consisting of a plurality of photovoltaic generators may comprise a plurality of parallel inverters, each receiving DC power from an array of photovoltaic panels, for example.

The insulation resistance Rₑ of the photovoltaic system may need to be measured before connecting the photovoltaic system to an external AC network. Depending on regulations, the insulation resistance Rₑ may need to be measured every time before connecting the photovoltaic system to an external AC network. The measurement time depends on DC field capacitance Cₑ and resistance. With a high DC field capacitance, the measurement time can be up to one hour or even more, for example. The measurement may be executed by injecting consecutive bipolar voltage pulses to the DC buses connecting the one or more photovoltaic panels 10 to the one or more inverters 20 and monitoring the resulting change of current in measurement resistors, for example. An example of such a measurement of the insulation resistance of a photovoltaic system is disclosed in EP 654673.

DE 10106200 discloses an insulation monitoring method that has a pulsed AC voltage connected between the unearthed network and earth, with calculation of the ohmic insulation resistance from the difference between successive measured values for the measuring current. A time constant for the network is determined for each pulse voltage value, with measurement of the measuring current at a multiple of the time constant and comparison with a control value for detection of measuring errors.

WO 2012/098677 discloses an insulation resistance detection circuit in which a CPU calculates an insulation resistance value of a direct-current power source using a first current value and a second current value, the first current value being measured on the basis of a voltage measured by a voltage measurement circuit and a current measured by a current measurement circuit, when a switch opens a circuit, and the second current value being measured on the basis of a voltage measured by the voltage measurement circuit and a current measured by the current measurement circuit, when the switch closes the circuit.

EP 2466320 discloses a process for measuring the electrical insulation resistance of a dc voltage source, such as a panel of photovoltaic cells or other device for generating direct electrical current, in which the dc voltage source is exposed simultaneously, in common mode, to at least two electrical voltage to earth values.

During the measurement procedure, short pulses are typically first injected to the DC buses DC+, DC- and the pulse length is increased if the pulse length used was too short for the measurement to settle because of the DC field capacitance Cₑ. The pulse length may be changed in predetermined steps. Typically, the measurement is always started from the shortest pulse length after the measurement is enabled and continued from the shortest pulse length towards the longest pulse length until a stable measurement result has been obtained. Thus the measurement adapts to possible changes in the DC field capacitance Cₑ and resistance Rₑ and changes the pulse length accordingly.

A problem with the above measurement solution is that the insulation resistance measurement, especially in a large utility scale PV generator, can take hours due to a high earth capacitance of the generator, whereby several measurement pulse lengths need to be used before obtaining a stable measurement. This, in turn, delays the starting of the PV system.

### BRIEF DESCRIPTION OF THE INVENTION

The object of the invention is thus to provide a method and an apparatus for implementing the method so as to solve or at least alleviate the above problem or at least to provide an alternative solution. The object of the invention is achieved with a method, a computer program product, an arrangement, and a system that are characterized by what is stated in the independent claims. Preferred embodiments of the invention are described in the dependent claims.

The invention is based on the idea of utilizing history data of measurement pulse lengths. Accordingly, an initial measurement pulse length value is set on the basis of a stored measurement pulse length value and the measurement of the insulation resistance of the photovoltaic system is then performed one or more times by starting from the thus set initial measurement pulse length value.

An advantage of the solution of the invention is that the time required to perform the measurement of the insulation resistance of the PV system can often be reduced.

### BRIEF DESCRIPTION OF THE FIGURES

In the following, the invention will be described in more detail in connection with preferred embodiments and with reference to the accompanying drawings, in which
Figure 1 is an example of a photovoltaic system according to an embodiment; and
Figure 2 is a flow chart according to an embodiment.

### DETAILED DESCRIPTION OF THE INVENTION

The application of the invention is not limited to any specific system, but it can be used in connection with various electric systems. Moreover, the use of the invention is not limited to systems employing any specific fundamental frequency or any specific voltage level.

Figure 1 illustrates an example of a photovoltaic system. The exemplary system of Figure 1 comprises one or more photovoltaic panels 10 which can supply DC power via a DC link to an inverter 20. The DC link has at least a positive connector DC+ and a negative connector DC-. The inverter 20 can convert the DC power to AC power, which may then be further supplied to an AC network, such as a three-phase AC network, for example. The insulation resistance Rₑ and the DC field capacitance Cₑ of the photovoltaic system are illustrated in a simplified manner in Figure 1.

Figure 1 further shows an example of a measuring arrangement 30 which can be used for measuring the insulation resistance Rₑ of the photovoltaic system. The exemplary measuring arrangement 30 comprises three resistances: a first resistance R1, a second resistance R2, and a third resistance R3 connected between the positive connector DC+ and the negative connector DC- of the DC link and the earth (ground). The three resistances R1, R2, R3 of the measuring arrangement 30 are of a known value and preferably comprised of high precision resistors in order to enable better measuring results. Values of the resistances R1, R2, R3 depend on the system characteristics. However, the first and second resistances R1, R2 are preferably of a relatively high value, e.g. about 100 kΩ or generally in the range of about 10 to 1000 kΩ, in order to reduce a current flow between the DC connectors DC+, DC- via the measuring circuit. The third resistance R3, in turn, is preferably of a relatively low value, e.g. about 500 Ω or generally in the range of about 100 to 1000 Ω, in order not to add too much resistance to the measuring circuit. The exemplary measuring arrangement 30 further comprises a voltage pulse generator 32 connected in series with the resistances R1, R2, R3, a voltage meter 33 connected in parallel to the third resistance R3, and a control unit 31. During the measurement of the insulation resistance Rₑ of the photovoltaic system, voltage pulses of a set length may be injected with the voltage pulse generator 32, under control by the control unit 31, to the DC connectors DC+, DC-. Voltage pulses are preferably injected in pairs such that first a positive voltage pulse is injected and then a negative voltage pulse is injected, or vice versa. The voltage of the voltage pulses may be about 40 V or generally in the range of about 10 to 100 V, for example, depending on the system characteristics. With the voltage meter 33 a current flowing through the third resistance R3 and consequently through the insulation resistance Rₑ can be determined. Instead of the voltage meter 33, the measuring arrangement 30 could comprise a current meter connected in series with the pulse generator 32, for example. Due to charging of the DC field capacitance Cₑ during the measurement, the measurement needs to settle before a reliable measurement result for the insulation resistance Rₑ can be obtained. The settling of the measurement may be generally determined by monitoring, either directly or indirectly, a time derivative (dl/dt) of the current (I) flowing through the third resistor R3 and, when the time derivative (or generally rate of change) of the current flowing through the third resistor R3 is below a predetermined threshold, the measurement can be determined to have settled. The settling of the measurement may also be determined in some other suitable way, for example.

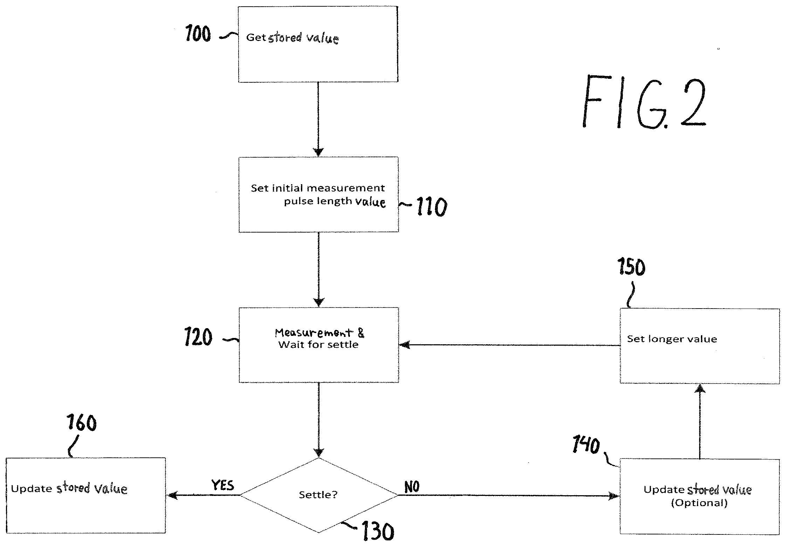

According to an embodiment, the measuring of the insulation resistance Rₑ of the photovoltaic system comprising at least one inverter 20 and at least one photovoltaic panel 10 may be performed as described in the following with reference to Figure 2. First, an initial measurement pulse length value may be set 110 on the basis of a stored measurement pulse length value. The stored measurement pulse length value may be readily stored in a memory of the entity performing the functionality, such as the control unit 31 in the example of Figure 1, or the stored measurement pulse length value may be first obtained 100 from another entity, for example. Such another entity may be a control unit of another photovoltaic system or a separate database which may be common to, or generally shared by, two or more separate photovoltaic systems, for example. Next, the measurement 120 of the insulation resistance Rₑ of the photovoltaic system may be performed one or more times by starting from the initial measurement pulse length value and after that each time increasing 150 the measurement pulse length value used until a stable measurement result is achieved. In the example of Figure 2, the measurement of the insulation resistance Rₑ of the photovoltaic system is performed 120 with the set measurement pulse length value and the settling of the measurement is waited for until the end of the respective measurement pulse. Then it is checked 130 whether the measurement settles during the respective measurement pulse and whether a reliable measurement result is obtained with the set measurement pulse length value. If the measurement is determined as not settled (NO in step 130), then the measurement pulse length value is increased 150. The increase 150 of the measurement pulse length value may be performed in a stepless or stepwise manner. In the case of stepwise increase of the measurement pulse length value, the measurement pulse length value may be increased 150 each time with a predetermined step. Moreover, the increasing steps may always be of equal length or the magnitude of the steps may vary. For example, the magnitude of the steps may decrease or increase each time the measurement pulse length value is increased. The total number of such increasing steps may also be predetermined. After each increase 150 of the measurement pulse length value, the measurement of the insulation resistance Rₑ of the photovoltaic system may be performed 120 with the newly set measurement pulse length value and the settling of the measurement is waited for until the end of the respective measurement pulse. Then it is again checked 130 whether the measurement settles during the respective measurement pulse and whether a reliable measurement result is obtained with the set measurement pulse length value. Finally, after the stable measurement result is achieved (YES in step 130), the stored measurement pulse length value may be updated 160 on the basis of the measurement pulse length value with which the stable measurement result was achieved. The updating 160 of the stored measurement pulse length value may comprise updating the value locally, e.g. the value stored in the control unit 31 in the example of Figure 1, or remotely, e.g. the value stored in another entity, such as in a control unit of another photovoltaic system or a separate database which may be common to, or generally shared by, two or more separate photovoltaic systems, for example. It is also possible, even if the measurement pulse length value is stored locally within the photovoltaic system, to transmit the updated value to one or more other photovoltaic systems. This enables the obtained measurement pulse length value to be used also in other photovoltaic systems such as individual DC fields of a photovoltaic plant comprising several separate DC fields.

According to an embodiment, the setting 110 of the initial measurement pulse length value comprises setting the initial measurement pulse length value to equal the stored measurement pulse length value, and the updating 160 of the stored measurement pulse length value comprises subtracting a predetermined value from the measurement pulse length value with which the stable measurement result was achieved, and setting the stored measurement pulse length value to equal the thus obtained value. Thus, according to this embodiment, a predetermined value is subtracted from the measurement pulse length value with which the stable measurement result was achieved in the updating step 160, and the value obtained after the subtraction is set as the stored measurement pulse length value. The predetermined value which is subtracted may be a constant value or it may correspond to one or more steps when the stepwise increase of the measurement pulse length value is used, for example. The benefit of performing the subtraction is to enable the stored measurement pulse length value to adapt also downward. For example, if the the DC field capacitance of the photovoltaic system decreases, the minimum measurement pulse length needed to obtain a stable measurement may decrease respectively.

According to an alternative embodiment, the setting 110 of the initial measurement pulse length value comprises subtracting a predetermined value from the stored measurement pulse length value, and setting the initial measurement pulse length value to equal the thus obtained value, and the updating 160 of the stored measurement pulse length value comprises setting the stored measurement pulse length value to equal the measurement pulse length value with which the stable measurement result was achieved. Thus, according to this alternative embodiment, the predetermined value is subtracted from the stored measurement pulse length value in the setting step 110, and the initial measurement pulse length value is then set to equal the value obtained after the subtraction. The predetermined value which is subtracted may be a constant value or it may correspond to one or more steps when the stepwise increase of the measurement pulse length value is used, for example. Also this embodiment provides the benefit that it enables the stored measurement pulse length value to adapt also downward.

The arrangement for measuring the insulation resistance of the photovoltaic system according to any one of the embodiments described herein could be implemented as a separate physical entity, such as a device, or it could be implemented at least partly within an existing device or element of a photovoltaic system. For example, such an arrangement could be implemented within the inverter 20 of the photovoltaic system. Thus, all or some of the components of the arrangement could reside inside the inverter 20. Also the control means 31 could reside at least partly inside the inverter 20 and they could be implemented at least partly by using the control system of the inverter 20, for example.

According to an embodiment, the control arrangement 31 or other possible control means controlling the arrangement for measuring the insulation resistance of the photovoltaic system according to any one of the embodiments, or a combination thereof, may be implemented as one physical unit or as two or more separate physical units that are configured to implement the functionality of the various embodiments. Herein the term 'unit' generally refers to a physical or logical entity, such as a physical device or a part thereof or a software routine. The control arrangement 31 according to any one of the embodiments may be implemented at least partly by means of one or more computers or corresponding digital signal processing (DSP) equipment provided with suitable software, for example. Such a computer or digital signal processing equipment preferably comprises at least a working memory (RAM) providing storage area for arithmetical operations, and a central processing unit (CPU), such as a general-purpose digital signal processor. The CPU may comprise a set of registers, an arithmetic logic unit, and a control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention, or a part thereof, may further comprise suitable input means for receiving e.g. measurement and/or control data, and output means for outputting e.g. control or other data. It is also possible to use a specific integrated circuit or circuits, or discrete electric components and devices for implementing the functionality according to any one of the embodiments.

The functionality of the various embodiments described herein can be implemented in existing inverters, for example. Present inverters may comprise processors and memory that can be utilized in the functions according to the various embodiments described above. Thus, modifications and configurations required for implementing an embodiment in existing inverters may be performed at least partly as software routines, which may be implemented as added or updated software routines. If at least part of the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory, e.g. a flash memory or an optical memory, from which it is loadable to the unit or units executing the program code. In addition, such a computer program code implementing the invention may be loaded to the unit or units executing the computer program code via a suitable data network, for example, and it may replace or update a possibly existing program code.

It is obvious to a person skilled in the art that as technology advances, the basic idea of the invention can be implemented in a variety of ways. Consequently, the invention and its embodiments are not restricted to the above examples, but can vary within the scope of the claims.

## Claims

1. A method for measuring an insulation resistance of a photovoltaic system comprising at least one inverter (20) and at least one photovoltaic panel (10) configured to supply the at least one inverter, the method comprising:
setting (110) an initial measurement pulse length value on the basis of a stored measurement pulse length value;
performing (120) the measurement of the insulation resistance of the photovoltaic system one or more times by starting from the initial measurement pulse length value and after that each time increasing (150) the measurement pulse length value used until a stable measurement result is achieved, wherein the measurement comprises injecting with a voltage pulse generator (32) voltage pulses having the measurement pulse length to DC connectors (DC+, DC-) connecting the at least one photovoltaic panel (10) and the at least one inverter (20) and wherein the measurement result is determined stable when during the measurement a rate of change of current flowing through the voltage pulse generator (32) is below a predetermined threshold; and
after the stable measurement result is achieved, updating (160) the stored measurement pulse length value on the basis of the measurement pulse length value with which the stable measurement result was achieved.

2. A method as claimed in claim 1, wherein
the setting (110) of the initial measurement pulse length value comprises setting the initial measurement pulse length value to equal the stored measurement pulse length value; and
the updating (160) of the stored measurement pulse length value comprises subtracting a predetermined value from the measurement pulse length value with which the stable measurement result was achieved, and setting the stored measurement pulse length value to equal the thus obtained value.

3. A method as claimed in claim 1, wherein
the setting (110) of the initial measurement pulse length value comprises subtracting a predetermined value from the stored measurement pulse length value, and setting the initial measurement pulse length value to equal the thus obtained value; and
the updating (160) of the stored measurement pulse length value comprises setting the stored measurement pulse length value to equal the measurement pulse length value with which the stable measurement result was achieved.

4. A method as claimed in claim 1, 2 or 3, wherein the measurement (120) comprises injecting a positive voltage pulse and a negative voltage pulse to DC connectors (DC+, DC-) connecting the at least one photovoltaic panel (10) and the at least one inverter (20).

5. A method as claimed in claim 4, wherein the measurement (120) comprises determining the insulation resistance of the photovoltaic system on the basis of currents flowing via the insulation resistance as a result of the injected voltage pulses.

6. A method as claimed in any one of claims 1 to 5, comprising receiving (100) the stored measurement pulse length value from another photovoltaic system.

7. A method as claimed in any one of claims 1 to 6, comprising transmitting (160) the updated stored measurement pulse length value to one or more other photovoltaic systems.

8. A computer program product comprising computer program code, wherein execution of the program code in a computer causes the computer to carry out the steps of the method according to any one of claims 1 to 7.

9. An arrangement for measuring an insulation resistance of a photovoltaic system comprising at least one inverter (20) and at least one photovoltaic panel (10) configured to supply the at least one inverter, the arrangement (30) comprising:
means (31) for setting an initial measurement pulse length value on the basis of a stored measurement pulse length value;
means (31, 32, 33, R1, R2, R3) for performing the measurement of the insulation resistance of the photovoltaic system one or more times by starting from the initial measurement pulse length value and after that each time increasing the measurement pulse length value used until a stable measurement result is achieved, comprising a voltage pulse generator (32) for injecting voltage pulses having the measurement pulse length to DC connectors (DC+, DC-) connecting the at least one photovoltaic panel (10) and the at least one inverter (20), wherein the measurement result is determined stable when during the measurement a rate of change of current flowing through the voltage pulse generator (32) is below a predetermined threshold; and
means (31) for updating, after the stable measurement result is achieved, the stored measurement pulse length value on the basis of the measurement pulse length value with which the stable measurement result was achieved.

10. An arrangement as claimed in claim 9, wherein
the means (31) for setting the initial measurement pulse length value are configured to set the initial measurement pulse length value to equal the stored measurement pulse length value; and
the means (31) for updating the stored measurement pulse length value are configured to subtract a predetermined value from the measurement pulse length value with which the stable measurement result was achieved, and set the stored measurement pulse length value to equal the thus obtained value.

11. An arrangement as claimed in claim 9, wherein
the means (31) for setting the initial measurement pulse length value are configured to subtract a predetermined value from the stored measurement pulse length value, and set the initial measurement pulse length value to equal the thus obtained value; and
the means (31) for updating the stored measurement pulse length value are configured to set the stored measurement pulse length value to equal the measurement pulse length value with which the stable measurement result was achieved.

12. An arrangement as claimed in claim 9, 10 or 11, wherein the means for performing the measurement comprise means (31, 32, R1, R2, R3) for injecting a positive voltage pulse and a negative voltage pulse to DC connectors (DC+, DC-) connecting the at least one photovoltaic panel (10) and the at least one inverter (20).

13. An arrangement as claimed in claim 12, wherein the means for performing the measurement comprise means (31, 33, R3) for determining the insulation resistance of the photovoltaic system on the basis of currents flowing via the insulation resistance as a result of the injected voltage pulses.

14. An arrangement as claimed in any one of claims 9 to 13, comprising means (31) for receiving the stored measurement pulse length value from another photovoltaic system.

15. An arrangement as claimed in any one of claims 9 to 14, comprising means (31) for transmitting the updated stored measurement pulse length value to one or more other photovoltaic systems.

16. A photovoltaic system comprising:
at least one inverter (20);
at least one photovoltaic panel (10) configured to supply the at least one inverter; and
an arrangement (30) according to any one of claims 9 to 15.

## Patentansprüche

1. Verfahren zum Messen eines Isolationswiderstands eines photovoltaischen Systems, das mindestens einen Wandler (20) und mindestens ein photovoltaisches Paneel (10), das dazu ausgelegt ist, den mindestens einen Wandler zu versorgen, umfasst, wobei das Verfahren Folgendes umfasst:
Einstellen (110) eines anfänglichen Messimpulslängenwerts auf Basis eines gespeicherten Messimpulslängenwerts;
Durchführen (120) der Messung des Isolationswiderstands des photovoltaischen Systems ein oder mehrere Male durch Beginnen beim anfänglichen Messimpulslängenwert und danach jedes Mal Erhöhen (150) des Messimpulslängenwerts, bis ein stabiles Messergebnis erreicht wird, wobei die Messung das Injizieren von Spannungsimpulsen, die die Messimpulslänge aufweisen, mit einem Spannungsimpulserzeuger (32) in DC-Verbinder (DC+, DC-), die das mindestens eine photovoltaische Paneel (10) und den mindestens einen Wandler (20) verbinden, umfasst und wobei bestimmt wird, dass das Messergebnis stabil ist, wenn während der Messung eine Änderungsrate eines Stroms, der durch den Spannungsimpulserzeuger (32) fließt, unter einem vorbestimmten Schwellwert liegt; und
wenn das stabile Messergebnis erreicht ist, Aktualisieren (160) des gespeicherten Messimpulslängenwerts auf Basis des Messimpulslängenwerts, mit dem das stabile Messergebnis erreicht wurde.

2. Verfahren nach Anspruch 1, wobei
das Einstellen (110) des anfänglichen Messimpulslängenwerts das Einstellen des anfänglichen Messimpulslängenwerts derart, dass er mit dem gespeicherten Messimpulslängenwert übereinstimmt, umfasst und
das Aktualisieren (160) des gespeicherten Messimpulslängenwerts das Subtrahieren eines vorbestimmten Werts vom Messimpulslängenwert, mit dem das stabile Messergebnis erreicht wurde, und Einstellen des gespeicherten Messimpulslängenwerts derart, dass er mit dem so erhaltenen Wert übereinstimmt, umfasst.

3. Verfahren nach Anspruch 1, wobei
das Einstellen (110) des anfänglichen Messimpulslängenwerts das Subtrahieren eines vorbestimmten Werts vom gespeicherten Messimpulslängenwert und das Einstellen des anfänglichen Messimpulslängenwerts derart, dass er mit dem so erhaltenen Wert übereinstimmt, umfasst und
das Aktualisieren (160) des gespeicherten Messimpulslängenwerts das Einstellen des gespeicherten Messimpulslängenwerts derart, dass er mit dem Messimpulslängenwert, mit dem das stabile Messergebnis erreicht wurde, übereinstimmt, umfasst.

4. Verfahren nach Anspruch 1, 2 oder 3, wobei die Messung (120) das Injizieren eines positiven Spannungsimpulses und eines negativen Spannungsimpulses in DC-Verbinder (DC+, DC-), die das mindestens eine photovoltaische Paneel (10) und den mindestens einen Wandler (20) verbinden, umfasst.

5. Verfahren nach Anspruch 4, wobei die Messung (120) das Bestimmen des Isolationswiderstands des photovoltaischen Systems auf Basis eines Stroms, der als Resultat der injizierten Spannungsimpulse via den Isolationswiderstand fließt, umfasst.

6. Verfahren nach einem der Ansprüche 1 bis 5, das das Empfangen (100) des gespeicherten Messimpulslängenwerts von einem anderen photovoltaischen System umfasst.

7. Verfahren nach einem der Ansprüche 1 bis 6, das das Übertragen (160) des aktualisierten gespeicherten Messimpulslängenwerts zu einem oder mehreren anderen photovoltaischen Systemen umfasst.

8. Computerprogrammprodukt, das Computerprogrammcode umfasst, wobei die Ausführung des Programmcodes in einem Computer bewirkt, dass der Computer die Schritte des Verfahrens nach einem der Ansprüche 1 bis 7 umsetzt.

9. Anordnung zum Messen eines Isolationswiderstands eines photovoltaischen Systems, das mindestens einen Wandler (20) und mindestens ein photovoltaisches Paneel (10), das dazu ausgelegt ist, den mindestens einen Wandler zu versorgen, umfasst, wobei die Anordnung (30) Folgendes umfasst:
ein Mittel (31) zum Einstellen eines anfänglichen Messimpulslängenwerts auf Basis eines gespeicherten Messimpulslängenwerts;
Mittel (31, 32, 33, R1, R2, R3) zum Durchführen der Messung des Isolationswiderstands des photovoltaischen Systems ein oder mehrere Male durch Beginnen beim anfänglichen Messimpulslängenwert und danach jedes Mal Erhöhen des Messimpulslängenwerts, bis ein stabiles Messergebnis erreicht wird, die einen Spannungsimpulserzeuger (32) zum Injizieren von Spannungsimpulsen, die die Messimpulslänge aufweisen, in DC-Verbinder (DC+, DC-), die das mindestens eine photovoltaische Paneel (10) und den mindestens einen Wandler (20) verbinden, umfassen, wobei bestimmt wird, dass das Messergebnis stabil ist, wenn während der Messung eine Änderungsrate eines Stroms, der durch den Spannungsimpulserzeuger (32) fließt, unter einem vorbestimmten Schwellwert liegt; und
ein Mittel (31) zum Aktualisieren des gespeicherten Messimpulslängenwerts auf Basis des Messimpulslängenwerts, mit dem das stabile Messergebnis erreicht wurde, nachdem das stabile Messergebnis erreicht wurde.

10. Anordnung nach Anspruch 9, wobei
das Mittel (31) zum Einstellen des anfänglichen Messimpulslängenwerts dazu ausgelegt ist, den anfänglichen Messimpulslängenwert derart einzustellen, dass er mit dem gespeicherten Messimpulslängenwert übereinstimmt; und
das Mittel (31) zum Aktualisieren des gespeicherten Messimpulslängenwerts dazu ausgelegt ist, einen vorbestimmten Wert vom Messimpulslängenwert, mit dem das stabile Messergebnis erreicht wurde, zu subtrahieren und den gespeicherten Messimpulslängenwert derart einzustellen, dass er mit dem so erhaltenen Wert übereinstimmt.

11. Anordnung nach Anspruch 9, wobei
das Mittel (31) zum Einstellen des anfänglichen Messimpulslängenwerts dazu ausgelegt ist, einen vorbestimmten Wert vom gespeicherten Messimpulslängenwert zu subtrahieren und den anfänglichen Messimpulslängenwert derart einzustellen, dass er mit dem so erhaltenen Wert übereinstimmt; und
das Mittel (31) zum Aktualisieren des gespeicherten Messimpulslängenwerts dazu ausgelegt ist, den gespeicherten Messimpulslängenwert derart einzustellen, dass er mit dem Messimpulslängenwert, mit dem das stabile Messergebnis erreicht wurde, übereinstimmt.

12. Anordnung nach Anspruch 9, 10 oder 11, wobei das Mittel zum Durchführen der Messung Mittel (31, 32, R1, R2, R3) zum Injizieren eines positiven Spannungsimpulses und eines negativen Spannungsimpulses in DC-Verbinder (DC+, DC-), die das mindestens eine photovoltaische Paneel (10) und den mindestens einen Wandler (20) verbinden, umfasst.

13. Anordnung nach Anspruch 12, wobei das Mittel zum Durchführen der Messung Mittel (31, 33, R3) zum Bestimmen des Isolationswiderstands des photovoltaischen Systems auf Basis eines Stroms, der als Resultat der injizierten Spannungsimpulse via den Isolationswiderstand fließt, umfasst.

14. Anordnung nach einem der Ansprüche 9 bis 13, die Mittel (31) zum Empfangen des gespeicherten Messimpulslängenwerts von einem anderen photovoltaischen System umfasst.

15. Anordnung nach einem der Ansprüche 9 bis 14, die Mittel (31) zum Übertragen des aktualisierten gespeicherten Messimpulslängenwerts zu einem oder mehreren anderen photovoltaischen Systemen umfasst.

16. Photovoltaisches System, das Folgendes umfasst:
mindestens einen Wandler (20);
mindestens ein photovoltaisches Paneel (10), das dazu ausgelegt ist, den mindestens einen Wandler zu versorgen; und
eine Anordnung (30) gemäß einem der Ansprüche 9 bis 15.

## Revendications

1. Procédé pour mesurer une résistance d'isolement d'un système photovoltaïque comprenant au moins un onduleur (20) et au moins un panneau photovoltaïque (10) configuré pour alimenter l'au moins un onduleur, le procédé comprenant :
le réglage (110) d'une valeur de longueur d'impulsion de mesure initiale sur la base d'une valeur de longueur d'impulsion de mesure stockée ;
la réalisation (120) de la mesure de la résistance d'isolement du système photovoltaïque une ou plusieurs fois en partant de la valeur de longueur d'impulsion de mesure initiale et ensuite en augmentant chaque fois (150) la valeur de longueur d'impulsion de mesure utilisée jusqu'à ce qu'un résultat de mesure stable soit atteint, dans lequel la mesure comprend l'injection, à l'aide d'un générateur d'impulsions de tension (32), d'impulsions de tension, ayant la longueur d'impulsion de mesure, dans des connecteurs à courant continu (CC+, CC-) connectant l'au moins un panneau photovoltaïque (10) et l'au moins un onduleur (20), et dans lequel le résultat de mesure déterminé comme étant stable lorsque, pendant la mesure, un taux de variation du courant circulant dans le générateur d'impulsions de tension (32) est en dessous d'un seuil prédéterminé ; et
après que le résultat de mesure stable a été atteint, la mise à jour (160) de la valeur de longueur d'impulsion de mesure stockée sur la base de la valeur de longueur d'impulsion de mesure à laquelle le résultat de mesure stable a été atteint.

2. Procédé selon la revendication 1, dans lequel
le réglage (110) de la valeur de longueur d'impulsion de mesure initiale comprend le réglage de la valeur de longueur d'impulsion de mesure initiale pour qu'elle soit égale à la valeur de longueur d'impulsion de mesure stockée ; et
la mise à jour (160) de la valeur de longueur d'impulsion de mesure stockée comprend la soustraction d'une valeur prédéterminée de la valeur de longueur d'impulsion de mesure à laquelle le résultat de mesure stable a été atteint, et le réglage de la valeur de longueur d'impulsion de mesure stockée pour qu'elle soit égale à la valeur ainsi obtenue.

3. Procédé selon la revendication 1, dans lequel
le réglage (110) de la valeur de longueur d'impulsion de mesure initiale comprend la soustraction d'une valeur prédéterminée de la valeur de longueur d'impulsion de mesure stockée, et le réglage de la valeur de longueur d'impulsion de mesure initiale pour qu'elle soit égale à la valeur ainsi obtenue ; et
la mise à jour (160) de la valeur de longueur d'impulsion de mesure stockée comprend le réglage de la valeur de longueur d'impulsion de mesure stockée pour qu'elle soit égale à la valeur de longueur d'impulsion de mesure à laquelle le résultat de mesure stable a été atteint.

4. Procédé selon la revendication 1, 2 ou 3, dans lequel la mesure (120) comprend l'injection d'une impulsion de tension positive et d'une impulsion de tension négative dans des connecteurs à courant continu (CC+, CC-) connectant l'au moins un panneau photovoltaïque (10) et l'au moins un onduleur (20).

5. Procédé selon la revendication 4, dans lequel la mesure (120) comprend la détermination de la résistance d'isolement du système photovoltaïque sur la base des courants circulant dans la résistance d'isolement à la suite des impulsions de tension injectées.

6. Procédé selon l'une quelconque des revendications 1 à 5, comprenant la réception (100) de la valeur de longueur d'impulsion de mesure stockée à partir d'un autre système photovoltaïque.

7. Procédé selon l'une quelconque des revendications 1 à 6, comprenant la transmission (160) de la valeur de longueur d'impulsion de mesure stockée mise à jour à un ou plusieurs autres systèmes photovoltaïques.

8. Produit de programme informatique comprenant un code de programme informatique, dans lequel l'exécution du code de programme dans un ordinateur amène l'ordinateur à effectuer les étapes du procédé selon l'une quelconque des revendications 1 à 7.

9. Dispositif pour mesurer une résistance d'isolement d'un système photovoltaïque comprenant au moins un onduleur (20) et au moins un panneau photovoltaïque (10) configuré pour alimenter l'au moins un onduleur, le dispositif (30) comprenant :
des moyens (31) pour régler une valeur de longueur d'impulsion de mesure initiale sur la base d'une valeur de longueur d'impulsion de mesure stockée ;
des moyens (31, 32, 33, R1, R2, R3) pour réaliser la mesure de la résistance d'isolement du système photovoltaïque une ou plusieurs fois en partant de la valeur de longueur d'impulsion de mesure initiale et ensuite en augmentant chaque fois la valeur de longueur d'impulsion de mesure utilisée jusqu'à ce qu'un résultat de mesure stable soit atteint, comprenant un générateur d'impulsions de tension (32) pour injecter des impulsions de tension, ayant la longueur d'impulsion de mesure, dans des connecteurs à courant continu (CC+, CC-) connectant l'au moins un panneau photovoltaïque (10) et l'au moins un onduleur (20), dans lequel le résultat de mesure est déterminé comme étant stable lorsque, pendant la mesure, un taux de variation du courant circulant dans le générateur d'impulsions de tension (32) est en dessous d'un seuil prédéterminé ; et
des moyens (31) pour mettre à jour, après que le résultat de mesure stable a été atteint, la valeur de longueur d'impulsion de mesure stockée sur la base de la valeur de longueur d'impulsion de mesure à laquelle le résultat de mesure stable a été atteint.

10. Dispositif selon la revendication 9, dans lequel
les moyens (31) pour régler la valeur de longueur d'impulsion de mesure initiale sont configurés pour régler la valeur de longueur d'impulsion de mesure initiale pour qu'elle soit égale à la valeur de longueur d'impulsion de mesure stockée ; et
les moyens (31) pour mettre à jour la valeur de longueur d'impulsion de mesure stockée sont configurés pour soustraire une valeur prédéterminée de la valeur de longueur d'impulsion de mesure à laquelle le résultat de mesure stable a été atteint, et régler la valeur de longueur d'impulsion de mesure stockée pour qu'elle soit égale à la valeur ainsi obtenue.

11. Dispositif selon la revendication 9, dans lequel
les moyens (31) pour régler la valeur de longueur d'impulsion de mesure initiale sont configurés pour soustraire une valeur prédéterminée de la valeur de longueur d'impulsion de mesure stockée, et régler la valeur de longueur d'impulsion de mesure initiale pour qu'elle soit égale à la valeur ainsi obtenue ; et
les moyens (31) pour mettre à jour la valeur de longueur d'impulsion de mesure stockée sont configurés pour régler la valeur de longueur d'impulsion de mesure stockée pour qu'elle soit égale à la valeur de longueur d'impulsion de mesure à laquelle le résultat de mesure stable a été atteint.

12. Dispositif selon la revendication 9, 10 ou 11, dans lequel les moyens pour réaliser la mesure comprennent des moyens (31, 32, R1, R2, R3) pour injecter une impulsion de tension positive et une impulsion de tension négative dans des connecteurs à courant continu (CC+, CC-) connectant l'au moins un panneau photovoltaïque (10) et l'au moins un onduleur (20).

13. Dispositif selon la revendication 12, dans lequel les moyens pour réaliser la mesure comprennent des moyens (31, 33, R3) pour déterminer la résistance d'isolement du système photovoltaïque sur la base de courants circulant via la résistance d'isolement à la suite des impulsions de tension injectées.

14. Dispositif selon l'une quelconque des revendications 9 à 13, comprenant des moyens (31) pour recevoir la valeur de longueur d'impulsion de mesure stockée à partir d'un autre système photovoltaïque.

15. Dispositif selon l'une quelconque des revendications 9 à 14, comprenant des moyens (31) pour transmettre la valeur de longueur d'impulsion de mesure stockée mise à jour à un ou plusieurs autres systèmes photovoltaïques.

16. Système photovoltaïque comprenant
au moins un onduleur (20) ;
au moins un panneau photovoltaïque (10) configuré pour alimenter l'au moins un onduleur ; et
un dispositif (30) selon l'une quelconque des revendications 9 à 15.
